# EUROPÄISCHE PATENTSCHRIFT

(11) **EP 1 063 551 B1**
(45) Veröffentlichungstag und Bekanntmachung des Hinweises auf die Patenterteilung: **02.06.2004**
(21) Anmeldenummer: 00108927.5
(22) Anmeldetag: 27.04.2000
(51) Int. Cl.: G02B 13/14, G02B 13/24

(54) **Objektiv, insbesondere Objektiv für eine Halbleiter-Lithographie-Projektionsbelichtungsanlage und Herstellungsverfahren**
Objective especially suited for semiconductor lithography projection imaging device and its production method
Objectif, en particulier objectif de lithographie semiconducteur par projection d'image et son procédé de fabrication

(30) Priorität: 26.06.1999 DE 19929403
(43) Veröffentlichungstag der Anmeldung: 27.12.2000
(73) Patentinhaber: Carl Zeiss SMT AG, 73447 Oberkochen (DE)
(72) Erfinder: Schuster, Karl-Heinz, 89551 Koenigsbronn (DE)
(74) Vertreter: Lorenz, Werner, Dr.-Ing.

(56) Entgegenhaltungen:
- EP-A- 0 347 838
- EP-A- 0 857 985
- DE-A- 3 123 799
- US-A- 5 889 617
- PATENT ABSTRACTS OF JAPAN vol. 018, no. 530 (P-1809), 6. Oktober 1994 (1994-10-06) & JP 06 186405 A (NIKON CORP), 8. Juli 1994 (1994-07-08)
- PATENT ABSTRACTS OF JAPAN vol. 017, no. 448 (P-1594), 17. August 1993 (1993-08-17) & JP 05 100102 A (OLYMPUS OPTICAL CO LTD), 23. April 1993 (1993-04-23)

## Beschreibung

Die Erfindung betrifft ein Verfahren zur Herstellung eines Projektionsbelichtungsobjektives und ein Projektionsbelichtungsobjektiv für eine Halbleiter-Lithographie-Projektionsbelichtungsanlage, mit mehreren in Fassungen gelagerten optischen Elementen.

Die in der Lithographie verwendeten Resiste werden zunehmend mit höheren Pulsleistungen und Pulszahlen eines Lasers belastet. Resiste bestehen im allgemeinen aus Kunststoff und werden bei der Beaufschlagung mit Laserlicht verändert, wobei sie Emissionen abgeben, welche für die optischen Elemente des in der Halbleiter-Lithographie-Projektionsbelichtungsanlage verwendeten Objektives schädlich sind. Dies gilt insbesondere für die optischen Abschlussflächen, die auf diese Weise im Laufe der Zeit ihre Brauchbarkeit verlieren.

Bekannt ist es deshalb, das Objektiv unter einen bestimmten Überdruck zu setzen, wozu kontinuierlich Gas eingeleitet wird, um die Optik stets sauber zu halten. Auf diese Weise wird verhindert, dass Verunreinigungen von außen nach innen dringen, denn im Inneren des Objektives herrscht stets ein leichter Überdruck. Auf der zu dem Resist gerichteten Seite ist das Objektiv mit einer Abschlussplatte versehen, die einen Schutz gegen Verunreinigungen von dem Resist bildet und gleichzeitig auch das Objektiv abdichtet (siehe Patent Abstracts of Japan Nr. 10054932 A).

Mit zunehmender Apertur und erhöhten Wellenfrontanforderungen neuerer Systeme in der Lithographie werden die nachgeschalteten planparallelen Abschlussplatten problematischer. Eine größere Apertur bei gleichbleibendem Bildfeld erhöht zwangsläufig den Plattendurchmesser und damit bei gleicher Dicke die Durchbiegung aufgrund von z.B. Gravitation. Ein bestimmter Betrag einer Durchbiegung verschlechtert jedoch die Wellenfront bei höherer Apertur deutlich. Zwar könnte eine dickere Abschlussplatte hier Abhilfe schaffen, aber diese erhöht nicht nur das Eigengewicht des Objektives, sondern kann darüber hinaus auch zu einer Aufheizung und daraus resultierende Bildqualitätsprobleme führen.

Aufgrund der vorstehend genannten Nachteile bei der Verwendung einer Abschlussplatte wird zum Teil versucht, auf die Abschlussplatte ganz zu verzichten. Bezüglich der optischen Auslegung eines Lithographie-Objektives ist dies kein Problem. Wird allerdings das letzte optische Element, sei es nun eine Linse oder auch die Abschlussplatte, unbrauchbar, z.B. aufgrund von Verunreinigungen durch das Resist, so muss das ganze Objektiv zu der optischen Firma bzw. zum Hersteller zurückgesandt werden, wo eine neue Linse gefertigt und die ganze Optik nachjustiert und abgestimmt werden muss. Die Fehler, die nämlich durch eine neue Linse bzw. Abschlussplatte eingeführt werden, sind in aller Regel so groß, dass eine neue Abstimmung unverzichtbar ist. Die neue Linse bzw. die Abschlussplatte weist zwangsweise Homogenitätsfehler, Oberflächenfehler und bei einer Linse auch einen Versatz und Zentrierfehler auf, wozu mechanische Zwänge durch die Fassung, in der die Linse eingesetzt ist, hinzukommen.

Aus der EP-A-0 857 985 A1 ist grundsätzlich ein Verfahren zur Herstellung eines dünnen optischen Elementes aus kristallinem Material bekannt, wobei an einem Rohling eine Fläche auf Endform bearbeitet wird, anschließend von dem Rohling eine dünne Scheibe abgetrennt wird, die Scheibe mit einem Hilfsstück verbunden wird, wonach abschließend die der zuvor bearbeiteten Fläche gegenüberliegende Fläche der Scheibe bearbeitet wird. Um ein verbessertes Ansprengverhalten zwischen einer Kristalllinse und einer Quarzlinse zu erreichen, wird dabei vor der Bearbeitung der zweiten Fläche eine Quarzschicht auf die Kristalllinse aufgebracht. Die Quarzschicht soll jedoch keine optische Wirkung besitzen.

In der DE 31 23 799 A1 ist ein asphärisches Glied beschrieben, bei dem zwei optische Elemente, nämlich eine asphärische und eines sphärische Linse, fassungsfrei miteinander verbunden sind. Durch diese Ausgestaltung soll z.B. bei Kondensoren für Polarisationsmikroskope und bei Fotoobjektiven das Problem gelöst werden, dass toleranzbehaftete Justierungen und mögliche Lageänderungen beim Bearbeiten zu Zentrierungsfehler führen. Um dies zu vermeiden, wird vorgeschlagen, eine asphärische und eine sphärische Linse gleichen Brechwertes mit jeweils einer optisch wirksamen Fläche unabhängig voneinander zur optischen Achse der Asphäre an einer gemeinsamen Trennfläche ohne optische Wirkung direkt miteinander zu verbinden, was z.B. durch ein Ansprengen an der Trennfläche erfolgen kann. Durch diese Ausgestaltung ist es möglich, den Krümmungsmittelpunkt der sphärischen Rückfläche dieses optischen Gliedes exakt zur optischen Achse der Asphäre zu justieren. Eine Auswechselbarkeit des optischen Gliedes ist nicht vorgesehen. Die beiden Linsen des optischen Gliedes sollen aus einem Material mit gleichem Brechwert bestehen und werden an der Trennfläche ohne optische Wirkung. zusammengefügt. Die Justierung bzw. Zentrierung erfolgt dabei innerhalb einer Justiervorrichtung mit einer Ringschneidenaufnahme 9.

Der vorliegenden Erfindung liegt die Aufgabe zugrunde, die vorstehend genannten Nachteile, insbesondere optische Fehler der Optik und/oder aufwändige Abstimmarbeiten bei einem Austausch des letzten optischen Elementes durch ein Verfahren und durch ein Projektionsbelichtungsobjektiv zu vermeiden, wobei das letzte optische Element, das gegenüber Beschädigungen und Verunreinigungen besonders gefährdet ist, bei Bedarf leicht ausgetauscht werden kann.

Erfindungsgemäß wird diese Aufgabe durch die im kennzeichnenden Teil von Anspruch 1 genannten Verfahrensmerkmale gelöst.

In Anspruch 4 ist ein Projektionsbelichtungsobjektiv zur Lösung dieser Aufgabe beschrieben.

Dadurch, dass das letzte optische Element fassungsfrei direkt mit dem vorletzten optischen Element verbunden wird bzw. ist, ist bei seinem Austausch keine erneute Abstimmung erforderlich. Dies bedeutet, eine Rücksendung zum Hersteller ist nicht mehr nötig. Ein Fachmann, der ein geeignetes optisches Element vorrätig hat, kann bei Bedarf direkt vor Ort das beschädigte letzte optische Element auswechseln. Dies kann z.B. in einem Reinraum am Objektiv direkt aufgrund der auswechselbaren bzw. lösbaren Verbindung des letzten optischen Elementes mit dem vorletzten optischen Element in einer sauberen Umgebung mühelos und in kurzer Zeit erfolgen.

Wenn in einer sehr vorteilhaften Weiterbildung der Erfindung dabei vorgesehen ist, dass das letzte optische Element als dünne äquidistante Platte ausgebildet wird, dann können jedwede Einstell- oder Abstimmungsarbeiten entfallen, denn optisch spielt es dann keine Rolle wie genau die äquidistante Platte seitlich sitzt oder wie genau sie zentriert ist, da sie (gekrümmt oder eben) an jeder Stelle gleich dick ist.

Die Herstellung einer derartigen dünnen Scheibe mit einer entsprechenden Genauigkeit bzw. mit Vermeidung von Materialfehlern ist jedoch problematisch bzw. eine derartige Platte muss entsprechend genau sein, damit sie ohne Veränderung der optischen Eigenschaften des Objektives in der erfindungsgemäßen Weise vor Ort anstelle des beschädigten optischen Elementes eingesetzt werden kann. Mit dem erfindungsgemäßen Verfahren lässt sich dies auf relativ einfache Weise erreichen. Dies wird insbesondere durch die Bearbeitung an einem Hilfsstück möglich, dessen Werte bekannt sind, weshalb die Durchtrittswerte der auf dem Hilfsstück zu bearbeitenden Scheibe bzw. Platte, die später als neues optisches Element verwendet werden soll, den Erfordernissen entsprechend durch eine Bearbeitung der Oberflächen angepasst werden kann.

Eine weitere sehr vorteilhafte Ausgestaltung der Erfindung kann darin bestehen, dass das letzte optische Element durch Ansprengen mit dem vorletzten optischen Element verbunden wird bzw. ist. Auf diese Weise wird eine einfache fassungsfreie und auswechselbare Verbindung des letzten optischen Elementes mit dem vorletzten optischen Element erreicht. In diesem Fall liegen die beiden optischen Elemente ohne Luft aneinander, was in der Fügetechnik als "Ansprengen" oder "physical glue" bezeichnet wird. Beim Ansprengen werden die Atomkräfte auf ganz kurze Distanz ausgenützt.

Bei Verwendung eines letzten optischen Elementes aus kristallinem Material wird man in vorteilhafter Weise auf der dem vorletzten optischen Element zugewandten Seite eine amorphe anorganische Schicht, z.B. Quarzglas, aufbringen. Zwar ist grundsätzlich auch ein Ansprengen eines optischen Elementes aus kristallinem Material möglich, aber da die Kristalle, wie z.B. Kalziumfluorid oder Kaliumfluorid, bezüglich ihrer Atomkräfte nach außen nur eine geringere Fernwirkung haben, wird durch das Aufbringen einer amorphen anorganischen Schicht, z.B. ein Aufdampfen, erreicht, dass bei diesem Aufdampfen z.B. die Atome von Siliciumoxid im Vakuum in die Kristallstruktur eindringen, womit eine bessere Haftung erreicht wird.

Als letztes optisches Element kann die bekannte Abschlussplatte vorgesehen sein oder anstelle einer gesonderten Abschlussplatte auch das letzte optische Element, nämlich die letzte Linse des Objektives. Im letzteren Falle bedeutet dies eigentlich, dass man die letzte Linse nunmehr zweiteilig ausbildet, wobei das äußere Teil im Vergleich zum inneren Teil in einer erfindungsgemäßen Ausgestaltung sehr dünn ist und die fassungsfreie Verbindung zwischen dem äußeren Teil und dem inneren Teil der Linse liegt. Mit anderen Worten, das innere Teil der Linse ist in bekannter Weise in einer Fassung gehalten, während das äußere Teil der Linse fassungsfrei und auswechselbar mit dem inneren Teil der letzten Linse verbunden ist. In diesem Falle entfällt die bekannte Abschlussplatte ersatzlos.

Weitere vorteilhafte Ausgestaltungen des Objektives ergeben sich aus den übrigen Unteransprüchen und dem nachfolgend anhand der Zeichnung prinzipmäßig beschriebenen Ausführungsbeispiel.

Es zeigt:
- Figur 1: eine letzte Linse eines Objektives mit einer daran angesprengten äquidistanten optischen Platte;
- Figur 2: eine vergrößerte Darstellung des strichpunktierten Kreises X in der Fig. 1 mit Beschichtungsflächen zwischen der Linse und einer optischen Platte als letztem optischen Element;
- Figur 3: eine vergrößerte Darstellung des strichpunktierten Kreises X in der Fig. 1 mit Beschichtungsflächen zwischen der Linse und einer optischen Platte mit einer zweigeteilten Linse als letztem optischen Element;
- Figur 4: ein Grundkörper, von dem eine dünne Scheibe bzw. Platte abgetrennt wird;
- Figur 5: die Anordnung einer dünnen Scheibe bzw. Platte als letztes optisches Element an einem Hilfsstück zur Bearbeitung, und
- Figur 6: ein Objektiv mit mehreren Linsen.

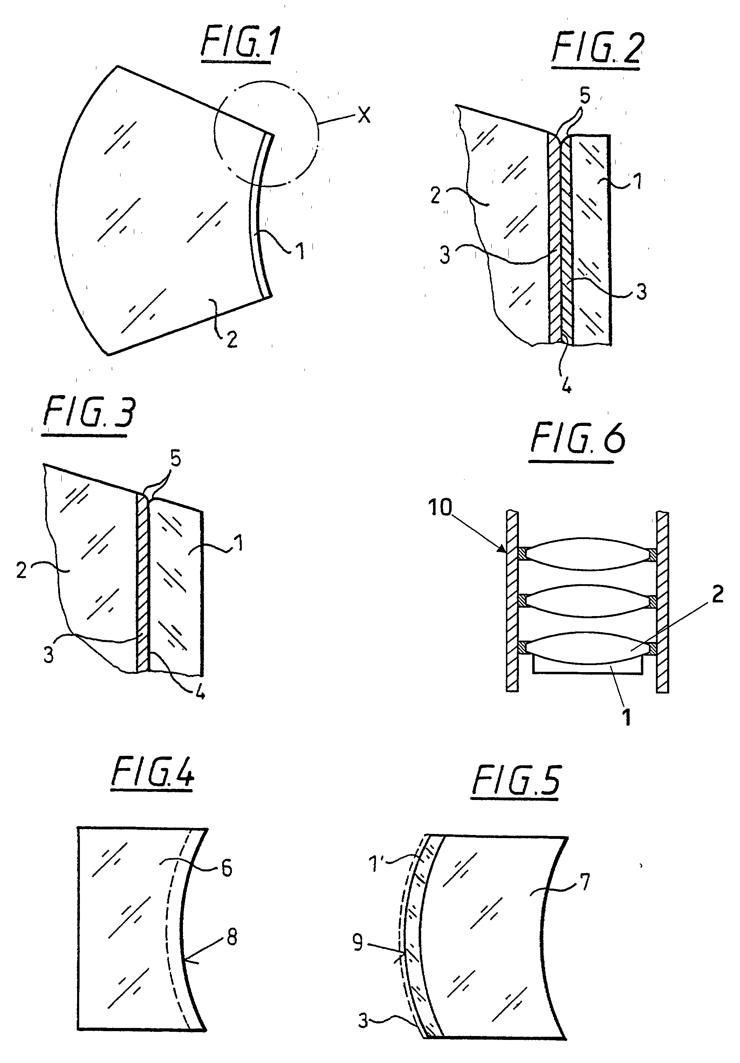

Wie aus der Fig. 1 ersichtlich ist, ist das letzte optische Element 1 eines in der Fig. 6 nur prinzipmäßig und vereinfacht dargestellten Objektives 10, das mit mehreren in Fassungen gelagerten Linsen als optische Elemente versehen ist, in einer Halbleiter-Lithographie-Projektionsbelichtungsanlage ohne eine Fassung direkt auf dem nunmehr vorletzten optischen Element 2 des Objektives 10 gehalten. Die Verbindung erfolgt durch ein sogenanntes Ansprengen, d.h. die beiden optischen Elemente 1 und 2 liegen ohne Luft direkt aneinander an. Wenn die Linse 2 aus kristallinem Material, z.B. einem Fluorid wie CaF₂, MgF₂ oder NaF besteht, dann wird zur Verbesserung der Ansprengung eine dünne Schicht 3 aus amorphem anorganischem Material, wie z.B. Quarzglas (SiO₂), auf einer Ansprengfläche 4 der Linse 2 aufgebracht. Die dünne Schicht 3 kann mit bekannten Techniken aufgebracht werden, wie z.B. ein Aufsputtern von SiO₂ auf MgF₂, was eine gut haftende Schicht mit guter Glättungswirkung ergibt.

Die dünne Schicht 3 kann auch aus dem gleichen Stoff, aber in amorpher Form, wie die Linse 2 bestehen, wobei dann natürlich die Adhäsion zwar nicht verbessert ist, aber die Glättung wirkt.

Aus der Fig. 2 ist in vergrößerter Darstellung entsprechend dem Kreis X nach der Fig. 1 ein Ansprengen von zwei optischen Elementen 1 und 2 ersichtlich, bei dem beide optischen Elemente 1 und 2 aus einem Kristall bestehen. In diesem Falle sind beide optischen Elemente mit einer Bedampfung aus SiO₂ oder Al₂O₃ an der Ansprengfläche 4 versehen.

Die Fig. 3 zeigt in vergrößerter Darstellung eine ähnliche Ausgestaltung, wobei lediglich eine Bedampfung des optischen Elementes 2, nämlich der Linse, an der Ansprengfläche 4 vorgenommen worden ist.

Aus den beiden vergrößerten Darstellungen in den Figuren 2 und 3 ist auch ersichtlich, dass beide optischen Elemente 1 und 2 an der Ansprengfläche 4 jeweils mit einer rundpolierten Kante 5 versehen sind. Selbstverständlich kann es gegebenenfalls auch ausreichend sein, nur eine der beiden Kanten rund zu polieren. Die rundpolierte Kante 5 oder die rundpolierten Kanten 5 dienen als Absprenghilfe bei einem Austausch des letzten optischen Elementes 1 aufgrund eines Verschleißes bzw. einer Beschädigung durch ein nachgeordnetes Resist.

Auf der dem Resist zugewandten Seite ist das letzte optische Element 1 in üblicher Weise mit einer Entspiegelungsschicht versehen.

Das letzte optische Element 1 kann eine Abschlussplatte sein oder auch eine Linse, die z.B. als dünneres äußeres Teil von der letzten Linse 2 "abgetrennt" worden ist. Mit anderen Worten, in diesem Fall ist die letzte Linse des Objektives 10 zweiteilig ausgebildet mit einem inneren Teil und einem äußeren Teil, wobei das wesentlich dünnere äußere Teil fassungsfrei und durch Ansprengen mit dem inneren Teil der Linse verbunden ist.

Um die Dauerhaftigkeit der Ansprengung im Betrieb weiter zu erhöhen, ist es auch möglich, dem letzten optischen Element 1 bzw. der Abschlussplatte einen leicht flacheren Radius bzw. flacheren Bogenverlauf als dem vorletzten optischen Element 2 an der Ansprengfläche 4 zu geben. Nach dem Ansprengen liegen dann identische Radien vor. Das angesprengte Element, nämlich das letzte optische Element 1, übt jedoch durch geringe Biegekräfte etwas Druck auf den Ansprengrand aus. Da sich Ansprengungen in der Regel von der Mitte her lösen, lässt sich so die Dauerhaftigkeit der Ansprengung weiter verbessern.

Anhand der Figuren 4 und 5 wird nachfolgend eine mögliche Herstellungsform des letzten optischen Elementes 1 beschrieben.

An einem dickeren optischen Material als Basisstück 6 wird eine optische Fläche 8 bearbeitet und zwar entsprechend den Erfordernissen plan oder mit einem Radius. Gegebenenfalls wird diese optische Fläche 8 mit einer Haftschicht, z.B. SiO₂, versehen. Anschließend wird eine dünne Scheibe bzw. Platte z.B. mit einer Diamantsäge von dem Basisstück 6 abgesägt. Die äquidistante Scheibe bzw. Platte 1' wird an ein Hilfsstück 7 von sehr guter Homogenität mit sehr guten Oberflächen angesprengt. Auf dem Hilfsstück 7 wird dann die optische Fläche 9 der Platte 1', die der zuvor bearbeitenden optischen Fläche 8 gegenüberliegt und die an der späteren Ansprengfläche 4 zur Anlage kommt, bearbeitet.

Das Hilfsstück 7 selbst ist interferrometrisch im Durchgang sehr genau bekannt. Die der späteren Ansprengfläche zugewandte optische Fläche 9 wird nun unter Kontrolle der Oberfläche, abschließend unter Kontrolle des Durchtritts den Erfordernissen entsprechend gefertigt. Dies kann z.B. durch Roboterpolieren/Ionenstrahlpolieren erfolgen. Bei der Kontrolle der Platte 1' wird die Wellenfront des Hilfsstücks 7 abgezogen, womit der Durchtritt der dünnen Platte 1' übrig bleibt. Mit dünner Platte 1' ist hier etwa 0,5 bis 1,0 mm Dicke gemeint. Alle Einflüsse, wie etwa Bedampfung, Schichtdickenvariation (Haftschicht), Homogenität, Fehler der zuerst an dem Basisstück 6 bearbeiteten Oberfläche 8 werden erkannt, integral gemessen und können entsprechend beseitigt werden.

Mit einer derartigen Platte als optischem Element 1 lässt sich ein beschädigtes optisches Element eines Objektives 10 auf einfache Weise und schnell ersetzen Denkbar ist es, bereits bei der Auslieferung eines Objektives 10 werkseitig ein oder mehrere derartige Ersatzplatten 1 als Zubehör mit auszuliefern. Auf diese Weise ist es dann möglich, schon ab Werk das Objektiv 10 mit mehreren Ersatzplatten als qualifizierter Lieferumfang zu versehen.

## Patentansprüche

1. Verfahren zur Herstellung eines Projektionsbelichtungsobjektives für eine Halbleiter-Lithographie-Projektionsbelichtungsanlage, wobei als letztes optisches Element ein dünnes optisches Element aus kristallinem Material, insbesondere mit einer geringen Dicke von weniger als 5 mm, vorgesehen ist, **dadurch gekennzeichnet, dass** an einem Rohling (6) eine Fläche (8) auf Endform bearbeitet wird, anschließend von dem Rohling (6) eine dünne Scheibe (1') abgetrennt wird, die Scheibe (1') mit einem Hilfsstück (7) verbunden wird, wonach abschließend die der zuvor bearbeiteten Fläche (8) gegenüberliegende Fläche (9) der Scheibe (1') bearbeitet wird.

2. Verfahren nach Anspruch 1, **dadurch gekennzeichnet, dass** die dünne Scheibe (1') durch Ansprengen mit dem Hilfsstück (7) verbunden wird.

3. Verfahren nach Anspruch 1 oder 2, **dadurch gekennzeichnet, dass** die zuletzt bearbeitete Fläche (9) der Scheibe (1') mit einer amorphen anorganischen Schicht (3) beschichtet wird.

4. Projektionsbelichtungsobjektiv für eine Halbleiter-Lithographie-Projektionsbelichtungsanlage mit mehreren in Fassungen gelagerten optischen Elementen, **dadurch gekennzeichnet, dass** das in Strahlrichtung letzte optische Element (1) fassungsfrei und auswechselbar direkt mit dem vorletzten optischen Element (2) verbunden ist.

5. Projektionsobjektiv nach Anspruch 4, **dadurch gekennzeichnet, dass** das letzte optische Element als dünne äquidistante Platte (1) in gebogener oder ebener Form ausgebildet ist.

6. Projektionsobjektiv nach Anspruch 4 oder 5, **dadurch gekennzeichnet, dass** das letzte optische Element (1) durch Ansprengen mit dem vorletzten optischen Element (2) verbunden ist.

7. Projektionsobjektiv nach Anspruch 6, **dadurch gekennzeichnet, dass** an der Ansprengfläche (4) wenigstens eines der beiden optischen Elemente (1,2) mit einer rundpolierten Kante (5) versehen ist.

8. Projektionsobjektiv nach Anspruch 6 oder 7, **dadurch gekennzeichnet, dass** der Radius des letzten optischen Elementes (1) leicht flacher ist als der Radius des vorletzten optischen Elementes (2) an der Ansprengfläche (4).

9. Projektionsobjektiv nach einem der Ansprüche 4 bis 8, **dadurch gekennzeichnet, dass** das letzte optische Element (1) eine Abschlussplatte ist.

10. Projektionsobjektiv nach einem der Ansprüche 4 bis 8, **dadurch gekennzeichnet, dass** das letzte optische Element (1) eine Linse ist.

11. Projektionsobjektiv nach Anspruch 10, **dadurch gekennzeichnet, dass** die Linse (1) zweiteilig ausgebildet ist, wobei das äußere Teil (1) im Vergleich zum inneren Teil (2) sehr dünn ist, und wobei die fassungsfreie Verbindung zwischen dem äußeren Teil (1) und dem inneren Teil (2) der Linse liegt.

12. Projektionsobjektiv nach einem der Ansprüche 4 bis 11, **dadurch gekennzeichnet, dass** bei Verwendung eines letzten optischen Elementes (1) aus kristallinem Material auf der dem vorletzten optischen Element (2) zugewandten Seite eine amorphe anorganische Schicht (3) aufgebracht ist.

13. Projektionsobjektiv nach einem der Ansprüche 4 bis 11, **dadurch gekennzeichnet, dass** bei Verwendung eines vorletzten und eines letzten optischen Elementes (1) aus kristallinem Material bzw. bei einer zweiteiligen Linse als letztem optischen Element aus kristallinem Material die optischen Elemente (1,2) an der Ansprengfläche (4) jeweils mit einer amorphen anorganischen Schicht (3) versehen sind.

14. Projektionsobjektiv nach Anspruch 12 oder 13, **dadurch gekennzeichnet, dass** das kristalline Material ein Fluorid ist.

15. Projektionsobjektiv nach Anspruch 12 oder 13, **dadurch gekennzeichnet, dass** die amorphe anorganische Schicht (3) eine oxydische Schicht ist.

16. Projektionsobjektiv nach Anspruch 15, **dadurch gekennzeichnet, dass** die oxydische Schicht aus Quarzglas besteht.

## Claims

1. Method for manufacturing a projection exposure objective for a semiconductor-lithography projection exposure apparatus, a thin optical element of crystalline material with, in particular, a low thickness of less than 5 mm being provided as the last optical element, **characterised in that** on a blank (6) a face (8) is machined to its final shape, a thin slice (1') is then separated from the blank (6), the slice (1') is joined to an auxiliary part (7) and the face (9) opposite the previously-machined face (8) of the slice (1') is then machined.

2. Method according to claim 1, **characterised in that** the thin slice (1') is joined to the auxiliary part (7) by physical gluing.

3. Method according to claim 1 or 2, **characterised in that** the last-machined face (9) of the slice (1') is coated with an amorphous inorganic layer (3).

4. Projection exposure objective for a semiconductor-lithography projection exposure apparatus having a plurality of optical elements held in mountings, **characterised in that** the last optical element (1) in the direction of the beam is joined without a mounting and in an exchangeable manner directly to the penultimate optical element (2).

5. Projection objective according to claim 4, **characterised in that** the last optical element is configured as a thin equidistant plate (1) having a curved or flat shape.

6. Projection objective according to claim 4 or 5, **characterised in that** the last optical element (1) is joined to the penultimate optical element (2) by physical gluing.

7. Projection objective according to claim 6, **characterised in that** a round-polished edge (5) is provided on the face (4) for physical gluing of at least one of the two optical elements (1, 2).

8. Projection objective according to claim 6 or 7, **characterised in that** the radius of the last optical element (1) is slightly flatter than the radius of the penultimate optical element (2) on its face (4) for physical gluing.

9. Projection objective according to any one of claims 4 to 8, **characterised in that** the last optical element (1) is a closing plate.

10. Projection objective according to any one of claims 4 to 8, **characterised in that** the last optical element (1) is a lens.

11. Projection objective according to claim 10, **characterised in that** the lens (1) is formed in two parts, the outer part (1) being very thin in comparison to the inner part (2) and the mounting-free join being located between the outer part (1) and the inner part (2) of the lens.

12. Projection objective according to any one of claims 4 to 11, **characterised in that** when a last optical element (1) of crystalline material is used, an amorphous inorganic layer (3) is applied to the side facing towards the penultimate optical element (2).

13. Projection objective according to any one of claims 4 to 11, **characterised in that** when a penultimate and a last optical element (1) of crystalline material are used, or when a two-part lens is used as the last optical element of crystalline material, the optical elements (1, 2) are provided in each case with an amorphous inorganic layer (3) on their face (4) for physical gluing.

14. Projection objective according to claim 12 or 13, **characterised in that** the crystalline material is a fluoride.

15. Projection objective according to claim 12 or 13, **characterised in that** the amorphous inorganic layer (3) is an oxidic layer.

16. Projection objective according to claim 15, **characterised in that** the oxidic layer consists of quartz glass.

## Revendications

1. Procédé de fabrication d'un objectif d'exposition de projection pour un dispositif d'exposition de projection pour lithographie de semi-conducteur dans lequel un élément optique mince en un matériau cristallin, en particulier avec une épaisseur faible de moins de 5 mm, est prévu comme dernier élément optique, **caractérisé en ce qu'**une surface (8) est travaillée en pièce finie sur une ébauche (6), qu'un disque mince (1') est ensuite séparé de l'ébauche (6), que le disque (1') est lié à une pièce auxiliaire (7), et enfin que la surface (9) du disque (1') se trouvant face à la surface précédemment travaillée (8) est travaillée.

2. Procédé selon la revendication 1, **caractérisé en ce que** le disque mince (1') est lié à la pièce auxiliaire (7) par plaquage.

3. Procédé selon la revendication 1 ou 2, **caractérisé en ce que** la surface (9) du disque (1') travaillée en dernier est recouverte d'une couche amorphe inorganique (3).

4. Objectif d'exposition de projection pour un dispositif d'exposition de projection pour lithographie de semi-conducteur avec plusieurs éléments optiques placés dans des supports, **caractérisé en ce que** le dernier élément optique (1) dans la direction du rayon est lié, de manière interchangeable et sans support, directement à l'avant-dernier élément optique (2).

5. Objectif de projection selon la revendication 4, **caractérisé en ce que** le dernier élément optique est conçu comme une plaque équidistante mince (1) de forme courbe ou plate.

6. Objectif de projection selon la revendication 4 ou 5, **caractérisé en ce que** le dernier élément optique (1) est lié à l'avant-dernier élément optique (2) par plaquage.

7. Objectif de projection selon la revendication 6, **caractérisé en ce que** la surface de plaquage (4) d'au moins un des deux éléments optiques (1, 2) est pourvue d'une arête polie en arrondi (5).

8. Objectif de projection selon la revendication 6 ou 7, **caractérisé en ce que** le rayon du dernier élément optique (1) est légèrement plus plan que le rayon de l'avant-dernier élément optique (2) sur la surface de plaquage (4).

9. Objectif de projection selon l'une des revendications 4 à 8, **caractérisé en ce que** le dernier élément optique (1) est une plaque d'obturation.

10. Objectif de projection selon l'une des revendications 4 à 8 **caractérisé en ce que** le dernier élément optique (1) est une lentille.

11. Objectif de projection selon la revendication 10, **caractérisé en ce que** la lentille (1) est formée de deux parties, la partie extérieure (1) étant très mince par rapport à la partie intérieure (2), et la liaison sans support se trouvant entre la partie extérieure (1) et la partie intérieure (2) de la lentille.

12. Objectif de projection selon l'une des revendications 4 à 11, **caractérisé en ce qu'**une couche amorphe inorganique (3) est appliquée sur la face tournée vers l'avant-dernier élément optique (2) lorsque l'on utilise un , dernier élément optique (1) en matériau cristallin.

13. Objectif de projection selon l'une des revendications 4 à 11, **caractérisé en ce que**, lors de l'utilisation d'un avant-dernier et d'un dernier élément optique (1) en matériau cristallin ou dans le cas d'une lentille en deux parties comme dernier élément en matériau cristallin, les éléments optiques (1, 2) soient pourvus chacun d'une couche amorphe inorganique (3) sur la surface de plaquage (4).

14. Objectif de projection selon la revendication 12 ou 13, **caractérisé en ce que** le matériau cristallin est un fluorure.

15. Objectif de projection selon la revendication 12 ou 13, **caractérisé en ce que** la couche amorphe inorganique (3) est une couche d'oxyde.

16. Objectif de projection selon la revendication 15, **caractérisé en ce que** la couche d'oxyde se compose de verre quartzeux.
